(19) Europäisches Patentamt
European Patent Office
Office européen des brevets

(11) **EP 3 960 890 A1**

(12) **EUROPÄISCHE PATENTANMELDUNG**

(43) Veröffentlichungstag:
**02.03.2022 Patentblatt 2022/09**

(21) Anmeldenummer: **20193903.0**

(22) Anmeldetag: **01.09.2020**

(51) Internationale Patentklassifikation (IPC):
**C22C 5/04** (2006.01)   **C22C 30/00** (2006.01)
**G01R 3/00** (2006.01)   **G01R 1/067** (2006.01)
**C22F 1/14** (2006.01)

(52) Gemeinsame Patentklassifikation (CPC):
**C22C 5/04; C22C 30/00; C22F 1/14; G01R 1/06755**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Heraeus Deutschland GmbH & Co. KG**
**63450 Hanau (DE)**

(72) Erfinder:
• **Dr. FECHER, Jonas**
**63450 Hanau (DE)**
• **STAUDT, Nicole**
**63450 Hanau (DE)**

(74) Vertreter: **Schultheiss & Sterzel Patentanwälte PartG mbB**
**Berner Straße 52**
**60437 Frankfurt am Main (DE)**

(54) **PALLADIUM-KUPFER-SILBER-RUTHENIUM-LEGIERUNG**

(57) Die Erfindung betrifft eine Palladium-Kupfer-Silber-Legierung mit Palladium als Hauptkomponente wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium und als Rest Palladium, Kupfer und Silber und maximal 1 Gew% andere metallische Elemente einschließlich Verunreinigungen enthält.

Die Erfindung betrifft auch ein Draht, ein Band oder eine Prüfnadel aus einer solchen Palladium-Kupfer-Silber-Legierung sowie die Verwendung einer solchen Palladium-Kupfer-Silber-Legierung zum Prüfen von elektrischen Kontakten oder zur elektrischen Kontaktierung oder zur Herstellung eines Schleifkontakts.

Figur 2

**EP 3 960 890 A1**

**Beschreibung**

Die Erfindung betrifft eine Palladium-Kupfer-Silber-Legierung (PdCuAg-Legierung) und einen Draht, ein Band oder eine Prüfnadel aus einer solchen Palladium-Kupfer-Silber-Legierung und die Verwendung einer solchen Palladium-Kupfer-Silber-Legierung zum Prüfen von elektrischen Kontakten oder zur elektrischen Kontaktierung oder zur Herstellung eines Schleifkontakts.

Während der Chipproduktion werden Wafer direkt nach der Prozessierung mit Prüfnadeln kontaktiert, um die Funktionsfähigkeit von integrierten Schaltungen (IC) in ungesägtem Zustand zu testen. Ein Array von Prüfnadeln testet dabei nach der Strukturierung der einzelnen Chips den Halbleiterwafer auf Funktionalität. Die Prüfnadeln sind in einer Testkarte (probe card) fixiert, die auf das Design des Wafers abgestimmt ist. Beim Prüfprozess wird der Wafer auf die Prüfnadeln gepresst und eine Kontaktierung zwischen Prüfnadeln und den Pads der ICs hergestellt, bei Aluminium Pads durch eine Passivierungsschicht hindurch hergestellt. Daraufhin werden verschiedene Parameter getestet, wie zum Beispiel die Kontaktierung, elektrische Kennwerte bei hoher Stromdichte und das elektrische Verhalten bei Temperaturwechseln.

Prüfnadeln werden also bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1).

Die Schlüsselparamater einer guten Prüfnadel sind eine hohe elektrische Leitfähigkeit, da hierbei hohe elektrische Ströme übertragen werden müssen, sowie eine hohe Härte, um die Wartungsintervalle gering zu halten. Aktuell werden für sogenannte "Probe Needles" (Prüfnadeln) demzufolge Metalle oder Legierungen verwendet, die eine hohe elektrische und thermische Leitfähigkeit aber auch hohe Härten und Zugfestigkeiten besitzen. Dabei dient die elektrische Leitfähigkeit von reinem Kuper (100% IACS = 58,1 * $10^6$ S/m) als Referenz. Kupfer (Cu) und Silber (Ag) können zu diesen Zwecken jedoch nicht eingesetzt werden, da sie deutlich zu duktil sind und sich die Prüfnadel beim Einsatz verformen würde.

Neben Prüfnadeln profitieren aber auch andere Anwendungen, wie insbesondere Drähte für Schleifkontakte, von Materialien mit hohen elektrischen und thermischen Leitfähigkeiten und gleichzeitig guten mechanischen Eigenschaften, wie einer hohen Härte und Zugfestigkeit. Bei Schleifkontakten ist es wichtig, dass einerseits durch die Oberflächen ein geringer Übergangswiderstand verursacht wird und andererseits das Material sich nicht zu schnell abnutzt also abreibt oder erodiert.

Anwendungen wie Prüfnadeln (Probe Needles) oder Schleifdrähte in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung.

Typische Materialien für Prüfnadeln sind ausscheidungsgehärtete Palladium-Silber-Legierungen, die 10% Gold und 10% Platin enthalten können und beispielsweise unter den Produktnamen Paliney® 7, Hera 6321 und Hera 648 vertrieben werden. Diese Legierungen weisen eine hohe Härte von 400-500 HV auf. Die elektrische Leitfähigkeit ist mit 9-12 % IACS aber eher gering. Die hohe Leitfähigkeit ist ein entscheidender Faktor bei Prüfnadeln. Für das Testen auf Aluminiumpads sind Prüfnadeln aus den Materialien Wolfram, Wolframcarbid, Palladium-Kupfer-Silber-Legierungen und Wolfram-Rhenium weit verbreitet. Diese sind besonders hart, wobei Aluminiumpads robuster als Goldpads sind und einer Prüfung mit harten Nadeln besser standhalten können als Goldpads. Auch diese Prüfnadeln haben keine sehr hohe elektrische Leitfähigkeit. Legierungen mit höherer elektrischer Leitfähigkeit wie CuAg7 sind weniger hart (ca. 320 HV1) und weniger warmfest als Palladium-Silber-Legierungen oder Palladium-Kupfer-Silber-Legierungen.

Für die Anwendung auf Goldpads sind Palladium-Legierungen (Pd-Legierungen) bekannt, wie beispielsweise Paliney® H3C der Firma Deringer Ney oder NewTec® der Firma Advanced Probing. Bereits aus der US 1 913 423 A und der GB 354 216 A sind grundsätzlich geeignete Palladium-Kupfer-Silber-Legierungen bekannt. Palladium-Kupfer-Silber-Legierung können eine Struktur mit einem Übergitter ausbilden, die zu einer Verbesserung der elektrischen Leitfähigkeit und der mechanischen Stabilität der Legierung führt. Die Atome in dem Gitter sind dann nicht mehr statistisch zufällig verteilt, sondern sie ordnen sich in periodischen Strukturen, dem Übergitter an. Hierdurch sind Härten von mehr als 350 HV1 (Vickers Härteprüfung nach DIN EN ISO 6507-1:2018 bis -4:2018 mit einer Prüfkraft von 9,81 N (1 Kilopond)), elektrische Leitfähigkeiten von mehr als 19,5% IACS und Bruchfestigkeiten bis zu 1500 MPa möglich.

Die US 2014/377 129 A1 und die US 5 833 774 A offenbaren gehärtete Ag-Pd-Cu-Legierungen für elektrische Anwendungen. Derartige Palladium-Kupfer-Silber-Legierungen weisen eine elektrische Leitfähigkeit von etwa 9% bis 12% IACS und eine Härte von 400 bis 500 HV1 auf. Eine höhere elektrische Leitfähigkeit wäre wünschenswert. Die US 10 385 424 B2 offenbart eine Palladium-Kupfer-Silber-Legierung zusätzlich enthaltend bis zu 5 Gew% Rhenium. Diese Palladium-Kupfer-Silber-Legierung wird unter dem Produktnamen Paliney® 25 vertrieben. Hiermit kann die elektrische Leitfähigkeit deutlich erhöht werden und erreicht Werte von mehr als 19,5% IACS. Nachteilig ist hieran jedoch, dass Rhenium einen sehr hohen Schmelzpunkt von 3180 °C hat und daher aufwendig mit den anderen Metallen legiert werden muss. Auch die hohe Dichte von Rhenium (21 g/cm³) weicht erheblich von den Dichten der anderen Elemente (Palladium (Pd), Kupfer (Cu) und Silber(Ag)) ab, was ebenfalls das Legieren mit den anderen Elementen erschwert. Zudem oxidiert Rhenium bereits ab Temperaturen von 400 °C, was nahe der Anwendungstemperatur von Prüfnadeln ist. Oxide an der Oberfläche können die Funktion von Prüfnadeln und Schleifkontakten einschränken. Des Weiteren ist immer auch eine weitere Erhöhung der elektrischen Leitfähigkeit und/oder der Härte der Legierung für die Anwendung als Material für Prüfnadeln wünschenswert.

Die Aufgabe der Erfindung besteht also darin, die Nachteile des Stands der Technik zu überwinden. Insbesondere soll eine Legierung sowie ein Draht, ein Band oder eine Prüfnadel bereitgestellt werden, die eine hohe elektrische Leitfähigkeit bei gleichzeitig hoher Härte aufweisen, die aber gleichzeitig einfach in der Herstellung sind und eine möglichst hohe Oxidationsbeständigkeit an der Oberfläche haben. Der Formkörper soll möglichst kostengünstig herstellbar sein als vergleichbare Legierungen. Die Legierung und die Produkte sollen als Prüfnadeln zum Prüfen von elektrischen Kontaktierungen verwendbar sein.

Ziel der Erfindung ist es somit eine Legierung, wie die bekannten Palladium-Kupfer-Silber-Legierungen zu finden, die die mechanischen Eigenschaften (Härte, Streckgrenze, Federeigenschaften) bekannter Palladium-Kupfer-Silber-Legierung mit einer höheren elektrischen Leitfähigkeit verbindet. Derartige Palladium-Kupfer-Silber-Legierungen haben einen entscheidenden technischen Vorteil, insbesondere bei der Anwendung als Material für Prüfnadeln.

Eine weitere Aufgabe der Erfindung liegt darin eine Prüfnadel bereitzustellen, die die zuvor genannten Eigenschaften erfüllt. Ferner ist eine weitere Aufgabe in der Entwicklung eines Drahts für einen Schleifkontakt aufweisend mehrere Drähte aus einer solchen Legierung zu sehen.

Die Aufgaben der Erfindung werden gelöst durch eine Palladium-Kupfer-Silber-Legierung mit Palladium als Hauptkomponente wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium enthält und als Rest Palladium, Kupfer und Silber und maximal 1 Gew% andere metallische Elemente einschließlich Verunreinigungen enthält.

Ein Gewichtsverhältnis von Palladium zu Kupfer von mindestens 1,05 und maximal 1,6 bedeutet, dass das Palladium mit einem Gewicht von mindestens 105% und maximal 160% des Gewichts des in der Palladium-Kupfer-Silber-Legierung enthaltenen Kupfers in der Palladium-Kupfer-Silber-Legierung enthalten ist.

Dementsprechend bedeutet ein Gewichtsverhältnis von Palladium zu Silber von mindestens 3 und maximal 6, dass das Palladium mit einem Gewicht von mindestens dem dreifachen und maximal dem sechsfachen des Gewichts des in der Palladium-Kupfer-Silber-Legierung enthaltenen Silbers in der Palladium-Kupfer-Silber-Legierung enthalten ist.

Unter einer Mischung von mehreren Elementen wird vorzugsweise eine Mischung verstanden, bei der zumindest 0,1 Gew% aller dieser Elemente in der Palladium-Kupfer-Silber-Legierung enthalten sind.

Unter einer Hauptkomponente wird vorliegend das Element (in diesem Fall Palladium) verstanden, das hauptsächlich, also mengenmäßig der größte Bestandteil ist, dass also vorliegend mehr Palladium in der Palladium-Kupfer-Silber-Legierung enthalten ist als Kupfer oder Silber.

Unter einer Verunreinigung ist vorliegend eine durch die Darstellung aller beteiligten Elemente bedingte Verunreinigung zu verstehen.

Die Palladium-Kupfer-Silber-Legierung ist vorzugsweise zur Herstellung von Prüfnadeln und/oder Schleifkontakten geeignet.

Dass die Legierung mehr als 1 Gew% und bis maximal 6 Gew% Ruthenium und Rhodium beinhaltet bedeutet, dass die Summe der Gewichtsanteile von Ruthenium und Rhodium zusammen mehr als 1 Gew% und bis maximal 6 Gew% des Gewichts der gesamten Legierung ausmachen. Allgemein bedeutet, dass die Legierung mehr oder weniger oder genau X Gew% Ruthenium und Rhodium beinhaltet, dass die Summe der Gewichtsanteile von Ruthenium und Rhodium zusammen den entsprechenden prozentualen Anteil X Gew% des Gewichts der gesamten Legierung ausmachen.

Besonders bevorzugt hat die Legierung bei einer Mischung von Ruthenium und Rhodium 1,5 Gew% von Rhodium und Ruthenium zusammen.

Es kann vorgesehen sein, dass die Verunreinigungen in der Summe einen Anteil von maximal 0,9 Gew% in der Palladium-Kupfer-Silber-Legierung haben, bevorzugt von maximal 0,1 Gew%.

Hierdurch wird sichergestellt, dass die physikalischen Eigenschaften der Palladium-Kupfer-Silber-Legierung nicht oder möglichst wenig von den Verunreinigungen beeinflusst werden.

Des Weiteren kann vorgesehen sein, dass die Palladium-Kupfer-Silber-Legierung bis zu 1 Gew% Rhenium enthält, wobei bevorzugt die Palladium-Kupfer-Silber-Legierung weniger als 0,1 Gew% Rhodium enthält, besonders bevorzugt die Palladium-Kupfer-Silber-Legierung mehr als 1 Gew% und maximal 2 Gew% Ruthenium und zwischen 0,1 Gew% und 1 Gew% Rhenium enthält, ganz besonders bevorzugt mindestens 1,1 Gew% und maximal 1,5 Gew% Ruthenium und zwischen 0,2 Gew% und 0,8 Gew% Rhenium enthält, speziell bevorzugt 1,1 Gew% Ruthenium und 0,4 Gew% Rhenium enthält.

Die Palladium-Kupfer-Silber-Legierung enthält dabei vorzugsweise mehr als 1 Gew% und maximal 6 Gew% Ruthenium.

Diese Palladium-Kupfer-Silber-Legierung(en) haben experimentell überraschend eine besonders hohe elektrische Leitfähigkeit von 28% IACS (11 * $10^6$ S/m) bei gleichzeitig hoher Härte von 365 HV1 gezeigt. Vermutlich sind hierfür Ruthenium-Rhenium-Ausscheidungen an den Korngrenzen der Palladium-Kupfer-Silber-Legierung verantwortlich.

Ferner kann vorgesehen sein, dass die Palladium-Kupfer-Silber-Legierung mindestens 45 Gew% und maximal 55 Gew% Palladium, mindestens 30 Gew% und maximal 45 Gew% Kupfer und mindestens 8 Gew% und maximal 15 Gew% Silber enthält, bevorzugt die Palladium-Kupfer-Silber-Legierung mindestens 50 Gew% und maximal 53 Gew% Palladium, mindestens 35 Gew% und maximal 38 Gew% Kupfer und mindestens 9 Gew% und maximal 12 Gew% Silber enthält sowie mindestens 1,1 Gew% bis maximal 3 Gew% Ruthenium, Rhodium oder Ruthenium und Rhodium enthält, besonders bevorzugt die Palladium-Kupfer-Silber-Legierung mindestens 51 Gew% und maximal 52 Gew% Palladium, mindestens 36 Gew% und maximal 37 Gew% Kupfer und mindestens 10 Gew% und maximal 11 Gew% Silber enthält sowie mindestens 1,1 Gew% bis maximal 2 Gew% Ruthenium, Rhodium oder Ruthenium und Rhodium enthält und maximal 0,5 Gew% andere metallische Elemente, insbesondere zwischen 0,3 Gew% und 0,5 Gew% Rhenium enthält.

Palladium-Kupfer-Silber-Legierungen mit diesen Zusammensetzungen haben eine besonders hohe elektrische Leitfähigkeit aufgrund eines sich in der Legierung ausbildenden Übergitters durch eine gleichmäßige Ordnung der Palladium- und Kupfer-Atome im Kristallgitter anstelle einer zufälligen Verteilung der Palladium-Atome und der Kupfer-Atome im Kristallgitter. Dieser Effekt scheint überraschenderweise durch die in der Palladium-Kupfer-Silber-Legierung enthaltenen Ruthenium- oder Rhodium-Ausscheidungen verstärkt zu werden. Gleichzeitig ist eine hohe Härte gegeben.

Bevorzugt kann auch vorgesehen sein, dass die Palladium-Kupfer-Silber-Legierung schmelzmetallurgisch hergestellt ist und anschließend durch Walzen und Tempern gehärtet ist, wobei vorzugsweise die Palladium-Kupfer-Silber-Legierung eine Härte von mindestens 350 HV1 aufweist.

Hierdurch kann die Härte der Palladium-Kupfer-Silber-Legierung verbessert werden.

Erfindungsgemäße Palladium-Kupfer-Silber-Legierungen können sich auch dadurch auszeichnen, dass die Palladium-Kupfer-Silber-Legierung eine Härte von mindestens 350 HV1 aufweist.

Des Weiteren können sich erfindungsgemäße Palladium-Kupfer-Silber-Legierungen dadurch auszeichnen, dass die Palladium-Kupfer-Silber-Legierung eine elektrische Leitfähigkeit von mindestens 19% IACS aufweist.

Auch können sich erfindungsgemäße Palladium-Kupfer-Silber-Legierungen dadurch auszeichnen, dass die Palladium-Kupfer-Silber-Legierung eine Bruchfestigkeit von mindestens 1300 MPa aufweist.

Palladium-Kupfer-Silber-Legierungen mit diesen physikalischen Eigenschaften sind mit den erfindungsgemäßen Zugaben von Ruthenium und Rhodium möglich und eignen sich besonders zur Herstellung von Prüfnadeln.

Es kann ferner vorgesehen sein, dass die Palladium-Kupfer-Silber-Legierung Ausscheidungen von Ruthenium, Rhodium oder einer Mischung aus Ruthenium und Rhodium oder einer Mischung aus Ruthenium und Rhenium enthält, wobei bevorzugt zumindest 90 Vol% der Ausscheidungen an Korngrenzen der Palladium-Kupfer-Silber-Legierung angeordnet sind, besonders bevorzugt zumindest 99 Vol% der Ausscheidungen an Korngrenzen der Palladium-Kupfer-Silber-Legierung angeordnet sind.

Hierdurch werden die die mechanischen Eigenschaften, wie beispielsweise die Bruchfestigkeit und der Verformungswiderstand erhöht. Dadurch ist die Palladium-Kupfer-Silber-Legierung besser als Prüfnadel einsetzbar.

Des Weiteren kann vorgesehen sein, dass die Palladium-Kupfer-Silber-Legierung ein Gewichtsverhältnis von Palladium zu Kupfer von mindestens 1,2 und maximal 1,55 aufweist, bevorzugt ein Gewichtsverhältnis von Palladium zu Kupfer von mindestens 1,3 und maximal 1,5 aufweist, besonders bevorzugt ein Gewichtsverhältnis von Palladium zu Kupfer von mindestens 1,35 und maximal 1,45 aufweist, ganz besonders bevorzugt ein Gewichtsverhältnis von Palladium zu Kupfer von 1,41 aufweist.

Diese Gewichtsverhältnisse liefern Palladium-Kupfer-Silber-Legierungen mit besonders hoher elektrischer Leitfähigkeit.

Ferner kann vorgesehen sein, dass die Palladium-Kupfer-Silber-Legierung ein Gewichtsverhältnis von Palladium zu Silber von mindestens 3,5 und maximal 5,5 aufweist, bevorzugt ein Gewichtsverhältnis von Palladium zu Silber von mindestens 4 und maximal 5,5 aufweist, besonders bevorzugt ein Gewichtsverhältnis von Palladium zu Silber von mindestens 4,6 und maximal 5,2 aufweist, ganz besonders bevorzugt ein Gewichtsverhältnis von Palladium zu Silber von 4,9 aufweist.

Auch diese Gewichtsverhältnisse liefern Palladium-Kupfer-Silber-Legierungen mit besonders hoher elektrischer Leitfähigkeit.

Bevorzugt kann auch vorgesehen sein, dass die Palladium-Kupfer-Silber-Legierung zumindest 1,1 Gew% Ruthenium, Rhodium oder Ruthenium und Rhodium enthält.

Hierdurch werden die elektrische Leitfähigkeit und die mechanischen Eigenschaften der Palladium-Kupfer-Silber-Legierung verbessert.

Des Weiteren kann vorgesehen sein, dass die Palladium-Kupfer-Silber-Legierung maximal 5 Gew% Ruthenium, Rhodium oder Ruthenium und Rhodium enthält, bevorzugt maximal 4 Gew% Ruthenium, Rhodium oder Ruthenium und Rhodium enthält, besonders bevorzugt maximal 3 Gew% Ruthenium, Rhodium oder Ruthenium und Rhodium enthält, ganz besonders bevorzugt maximal 2 Gew% Ruthenium, Rhodium oder Wolfram Ruthenium und Rhodium enthält.

Auch diese Maßnahmen dienen der Erhöhung der elektrischen Leitfähigkeit der Palladium-Kupfer-Silber-Legierung.

Auch kann vorgesehen sein, dass die Palladium-Kupfer-Silber-Legierung mehr als 1 Gew% und bis maximal 6 Gew% Rhodium oder Ruthenium enthält, bevorzugt mehr als 1 Gew% und bis maximal 3 Gew% Rhodium oder Ruthenium enthält, besonders bevorzugt zumindest 1,1 Gew% und bis maximal 2 Gew% Rhodium oder Ruthenium enthält, ganz besonders bevorzugt 1,5 Gew% Rhodium oder 1,5 Gew% Ruthenium enthält.

Diese Palladium-Kupfer-Silber-Legierungen zeichnen sich durch eine besonders hohe mechanische Härte (HV1) aus.

Alternativ kann vorgesehen sein, dass die Palladium-Kupfer-Silber-Legierung mehr als 1 Gew% und bis maximal 6 Gew% Ruthenium und Rhenium enthält, bevorzugt zumindest 1,1 Gew% und bis maximal 3 Gew% Ruthenium und Rhenium enthält, besonders bevorzugt zumindest 1,1 Gew% und bis maximal 2 Gew% Ruthenium und Rhenium enthält, ganz besonders bevorzugt 1,1 Gew% Ruthenium und 0,4 Gew% Rhenium enthält.

Es kann dabei vorgesehen sein, dass mehr Ruthenium als Rhenium in der Palladium-Kupfer-Silber-Legierung enthalten ist.

Solche Palladium-Kupfer-Silber-Legierungen zeichnen sich durch eine besonders hohe elektrische Leitfähigkeit aus.

Die der vorliegenden Erfindung zugrundeliegenden Aufgaben werden auch gelöst durch ein Draht, ein Band oder eine Prüfnadel bestehend aus oder aufweisend eine erfindungsgemäße Palladium-Kupfer-Silber-Legierung, wobei vorzugsweise zumindest ein innerer Kern des Drahts, des Bands oder der Prüfnadel aus der Palladium-Kupfer-Silber-Legierung besteht.

Drähte, Bänder und Prüfnadeln aus solchen Palladium-Kupfer-Silber-Legierungen sind aufgrund ihrer hohen Härte, Elastizität und elektrischen Leitfähigkeit besonders gut für elektrische Kontaktmessungen geeignet.

Die der vorliegenden Erfindung zugrundeliegenden Aufgaben werden ferner gelöst durch eine Verwendung einer erfindungsgemäßen Palladium-Kupfer-Silber-Legierung oder eines erfindungsgemäßen Drahts oder Bands oder einer erfindungsgemäßen Prüfnadel zum Prüfen von elektrischen Kontakten oder zur elektrischen Kontaktierung oder zur Herstellung eines Schleifkontakts.

Für diese Anwendungen sind die Palladium-Kupfer-Silber-Legierung und die draus gefertigten Drähte, Bänder und Prüfnadeln besonders gut geeignet.

Der Erfindung liegt die überraschende Erkenntnis zugrunde, dass die erfindungsgemäßen Palladium-Kupfer-Silber-Legierungen eine hohe elektrische Leitfähigkeit mit einer hohen Härte und Bruchfestigkeit kombinieren und gleichzeitig unaufwendig in der Herstellung und/oder besonders hart sind. Die Dichte von Ruthenium (12,4 g/cm$^3$) und Rhodium (12 g/cm$^3$) und die Schmelzpunkte dieser Metalle (2334 °C für Ruthenium und 1964 °C für Rhodium) liegen wesentlich dichter bei denen von Palladium, Kupfer und Silber und sie lassen sich daher leichter mit diesen Metallen legieren als Metalle mit stärker abweichenden Dichten und Schmelzpunkten, wie beispielsweise Rhenium. Zudem ist die Oberfläche der Palladium-Kupfer-Silber-Legierungen auch bei hohen Temperaturen um die 400 °C oxidationsbeständig. Ruthenium und Rhodium bilden erst ab etwa 700 °C Oxide. Die aus den erfindungsgemäßen Legierungen hergestellten Drähte, Bänder und Prüfnadeln haben die entsprechenden vorteilhaften Eigenschaften. Es konnten sogar elektrische Leitfähigkeiten von 27% und 28% IACS erreicht werden, wenn eine Palladium-Kupfer-Silber-Legierung mit Ruthenium oder Ruthenium und Rhenium gemessen wird. Eine überraschend hohe Härte konnte bei einer Palladium-Kupfer-Silber-Legierung enthaltend Rhodium erzielt werden.

Mit der vorliegenden Erfindung sind elektrische Leitfähigkeiten von 23% IACS oder sogar mehr möglich. 100% IACS entsprechen 58 m / (Ohm mm$^2$).

Die Verwendung von Ruthenium oder Rhodium als Legierungsbestandteil von Palladium-Kupfer-Silber-Legierungen ist im Vergleich zur Verwendung von Rhenium aufgrund der unterschiedlichen chemischen Eigenschaften dieser Elemente überraschend. Verglichen mit Rhenium befinden sich Rhodium und Ruthenium sowohl in einer anderen Hauptgruppe als auch in einer anderen Periode des Periodensystems, was in erster Näherung auf sehr unterschiedliche Eigenschaften und unterschiedliches Legierungsverhalten schließen lässt. Rhodium und Ruthenium sind Platingruppenmetalle, während Rhenium zur Mangangruppe zählt, weshalb auch deshalb keine Eigenschaftsähnlichkeit erwartbar ist. Rhenium besitzt eine hexagonale Kristallstruktur während Rhodium kubisch flächenzentriert ist.

Ruthenium hat eine geringere Löslichkeit in Silber als Rhenium (2,65 x 10$^{-4}$ bei Rhenium im Vergleich zu 1,44 x 10$^{-3}$ bei Ruthenium). Dies sollte einen positiven Effekt auf die elektrische Leitfähigkeit der erfindungsgemäßen Palladium-Kupfer-Silber-Legierung haben. Zudem wurden bei elektronenmikroskopischen Untersuchungen in Palladium-Kupfer-Silber-Legierungen mit 1,1 Gew% bis 1,5 Gew% Ruthenium Ruthenium-Ausscheidungen an den Korngrenzen gefunden. Diese können durch Ausscheidungshärtung zu einer größeren Härte der Palladium-Kupfer-Silber-Legierung führen.

Die erfindungsgemäße Palladium-Kupfer-Silber-Legierung zeichnet sich durch eine hohe Härte, gute Federeigenschaften und gleichzeitig gute elektrische Leitfähigkeit aus. Sie ist daher für eine Anwendung als Material zur Herstellung von Prüfnadeln prädestiniert.

Bei einem Gewichtsverhältnis (1,05 bis 1,6) von Palladium und Kupfer kann durch entsprechende Wärmebehandlung eine geordnete Überstruktur im Kristallgitter (auch als "Superlattice" bezeichnet) eingestellt werden. Die regelmäßige Anordnung der Palladium- und Kupfer-Atome hat zur Folge, dass sowohl die Härte als auch die elektrische Leitfähigkeit der Palladium-Kupfer-Silber-Legierung ansteigen. Die Zulegierung von Silber im Verhältnis Palladium zu Silber zwischen 3 und 6 ermöglicht durch eine Ausscheidungshärtung eine zusätzliche Steigerung der Festigkeit. Die Zulegierung von Ruthenium, Rhodium oder Ruthenium und Rhodium in der Größenordnung von 1 Gew% bis 6 Gew% trägt überraschend zur Bildung feiner Körner bei, was Härte und Umformbarkeit der Palladium-Kupfer-Silber-Legierung positiv beeinflusst. Zudem verhindert das Ruthenium, Rhodium oder deren Mischung, die mutmaßlich bevorzugt an den Korngrenzen angeordnet sind, Kornwachstum und Kriechen bei der Einsatztemperatur. Dies bewirkt eine längere Haltbarkeit daraus gefertigter Prüfnadeln. Zu dem Ruthenium kann bis zu 1 Gew% Rhenium zulegiert werden. Die erreichte elektrische Leitfähigkeit ist bei 27% bis 30 % IACS bei einer Härte von mehr als 400 HV besonders gut für den Einsatz als Prüfnadel geeignet. Damit sind die physikalischen Eigenschaften der erfindungsgemäßen Palladium-Kupfer-Silber-Legierung mit Ruthenium bezüglich elektrischer Leitfähigkeit und Härte auch besser als die von Paliney® 25.

Im Folgenden werden Ausführungsbeispiele der Erfindung erläutert, ohne jedoch dabei die Erfindung zu beschränken.

Die nachfolgend beschriebenen Palladium-Kupfer-Silber-Legierungen wurden hergestellt, indem zunächst Vorlegierungen durch Induktionsschmelzen erzeugt wurden. Als Vorlegierungen wurden Palladium-Ruthenium-, Palladium-Rhenium- und Palladium-Rhodium-Vorlegierungen hergestellt. Die Herstellung der Vorlegierungen ist aufgrund der nicht zu stark voneinander abweichenden Schmelztemperaturen und Dichten der Elemente Palladium, Ruthenium und Rhodium unproblematisch und ohne großen Aufwand kostengünstig möglich.

Diese Vorlegierungen wurden anschließend mit Kupfer und Silber durch Lichtbogenschmelzen legiert. Anschließend werden die so erschmolzenen Formkörper durch Wärmebehandlungen und Walzen geformt und gehärtet. Hierzu wurden die Formkörper für 120 Minuten bei 900 °C getempert und abgeschreckt. Sie wurden bei Raumtemperatur mit mehreren Zwischenglühungen bei 900 °C und 120 Minuten an 0,4 mm gewalzt und anschließend bei 380 °C für 1,5 h ausgelagert, wodurch ein Härtungseffekt eintritt..

Anschließend wurden die elektrische Leitfähigkeit mit einer Vierpunktmessung bestimmt. Die Vierpunkt-Messmethode, auch Vierpunktmessung oder Vierspitzenmessung, ist ein Verfahren, um den Flächenwiderstand, also den elektrischen Widerstand einer Oberfläche oder dünnen Schicht, zu ermitteln. Bei dem Verfahren werden vier Messspitzen in einer Reihe auf die Oberfläche der Folie gebracht, wobei über die beiden äußeren Messspitzen ein bekannter Strom fließt und mit den beiden inneren Messspitzen der Potentialunterschied, das heißt, die elektrische Spannung zwischen diesen beiden inneren Messspitzen, gemessen wird. Da das Verfahren auf dem Prinzip der Vierleitermessung beruht, ist es weitgehend unabhängig vom Übergangswiderstand zwischen den Messspitzen und der Oberfläche (Prinzip Thomson-Brücke). Benachbarte Messspitzen haben jeweils den gleichen Abstand. Der Flächenwiderstand R ergibt sich aus der gemessenen Spannung U und dem Strom I nach der Formel:

$$R = \frac{\pi}{\ln 2} \frac{U}{I}$$

Um aus dem Flächenwiderstand R den spezifischen Widerstand p des Schichtmaterials zu errechnen, multipliziert man ihn mit der Dicke d (Schichtdicke) der Folie:

$$\rho = d\,R$$

Die elektrische Leitfähigkeit ergibt sich aus dem Kehrwert des spezifischen Widerstands.

Die Härte (HV1 - Vickers Härteprüfung nach DIN EN ISO 6507-1:2018 bis -4:2018 mit einer Prüfkraft von 9,81 N (1 Kilopond)), die Festigkeit wurde mittels Zugversuchen und die Mikrostruktur mittels metallographischen Schliffen untersucht.

Die folgenden Palladium-Kupfer-Silber-Legierungen wurden hergestellt und untersucht:

1. Pd51,5Cu36,5Ag10,5Ru1,5 (PdCuAgRu)
2. Pd51,5Cu36,5Ag10,5Ru1,1Re0,4 (PdCuAgRuRe)
3. Pd51,5Cu36,5Ag10,5Rh1,5 (PdCuAgRh)

Die Angaben beziehen sich immer auf Gewichtsprozent (Gew%) in der Legierung. Zudem enthalten die Legierungen übliche Verunreinigungen mit einer Konzentration von weniger als 0,1 Gew%.

Für den Vergleich wurde auch eine Palladium-Kupfer-Silber-Legierung mit dem Produktnamen Hera 6321 mit der Zusammensetzung 39 Gew% Pd, 31 Gew% Cu, 29 Gew% Ag, 0,9 Gew% Zn und 0,1 Gew% B untersucht.

Tabelle 1: Nachfolgend sind die Messergebnisse der elektrischen Leitfähigkeit (IACS) und der Härte zu den untersuchten Legierungen aufgelistet

| | IACS [%] | Härte [HV1] | Streckgrenze [MPa] |
|---|---|---|---|
| Hera 6321 | 9-12 | 400-500 | 1300 |
| PdCuAgRu | 27 | 360 | 1100 |
| PdCuAgRuRe | 28 | 365 | 1050 |
| PdCuAgRh | 23 | 429 | 1100 |

Die Messungen der PdCuAgRu-Legierung, der PdCuAgRuRe-Legierung und der PdCuAgRh-Legierung erfolgten an Blechen der Dicke 0,4 mm. Die Messung der Hera-6321-Legierung erfolgte an einem Blech der Stärke 54 μm.

Im Folgenden werden Mikrostrukturbilder der untersuchten Legierungen anhand von vier Figuren erläutert, Dabei zeigt:

Figur 1: ein Mikrostrukturbild der untersuchten Hera-6321-Legierung;

Figur 2: ein Mikrostrukturbild der untersuchten PdCuAgRu-Legierung;

Figur 3: ein Mikrostrukturbild der untersuchten PdCuAgRuRe-Legierung; und

Figur 4: ein Mikrostrukturbild der untersuchten PdCuAgRh-Legierung.

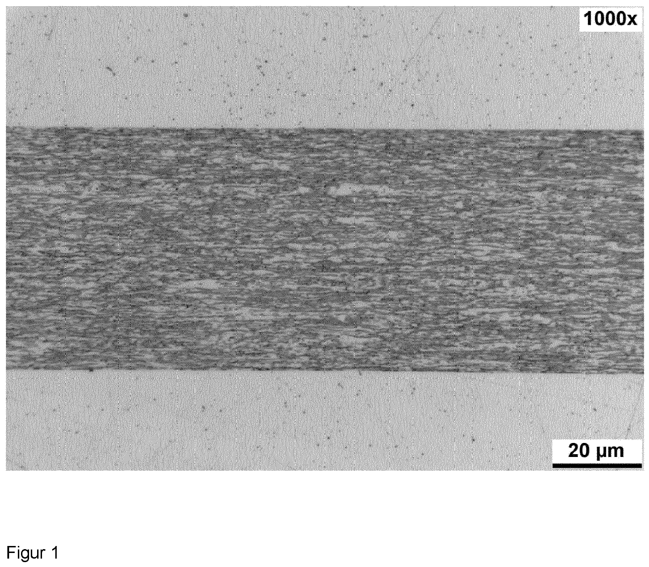

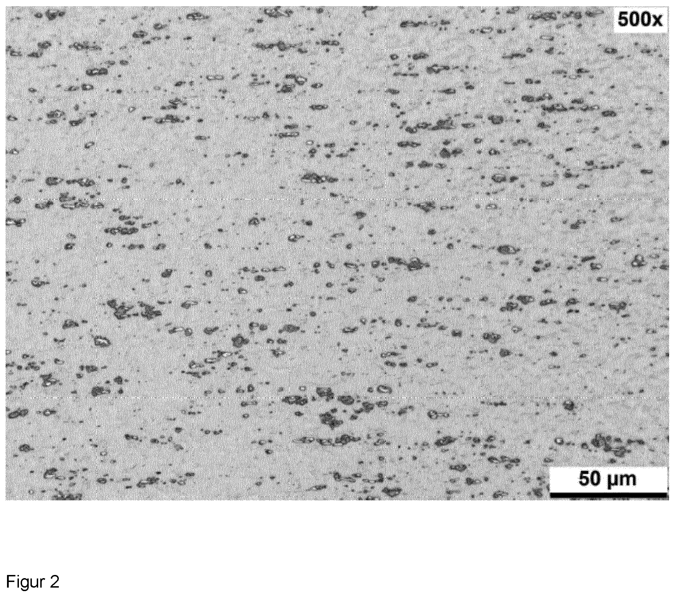

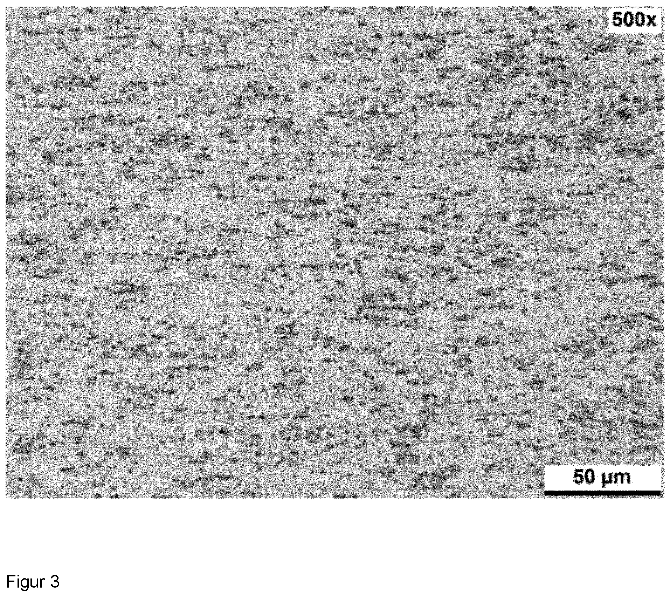

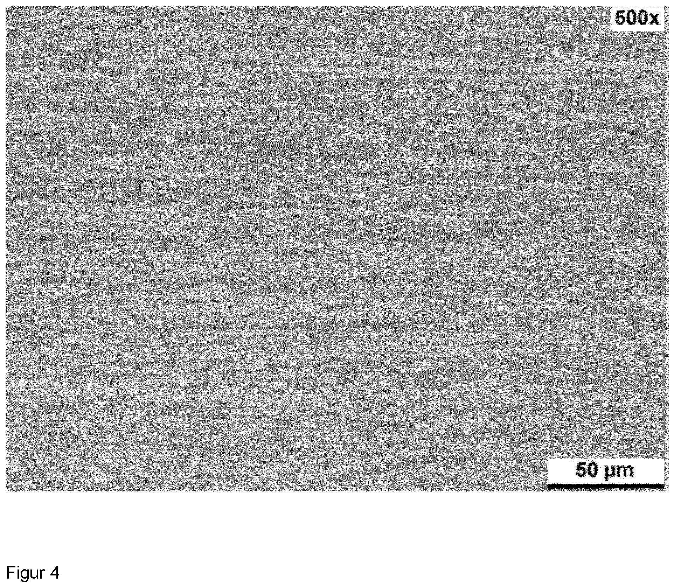

Alle Mikrostrukturbilder (Figuren 1 bis 4) zeigen die Legierungen im ausscheidungsgehärteten Zustand. Die Bilder wurden durch Aufnahmen von Schliffen durch die Legierungen mit dem Lichtmikroskop (Auflichtmikroskop, Hellfeld) aufgenommen. Die Oberflächen wurden mit Gefüge-Ätzungen vorbereitet, um die Ausscheidungen besser sichtbar zu machen. Die Ausscheidungen sind in den Figuren 2 bis 4 in den Legierungen als dunkle Kontraste in der hellen Matrix der Edelmetall-Legierung zu erkennen. In Figur 1 sind die Silber-Ausscheidungen in der Legierung als helle Kontraste in der dunklen Matrix zu erkennen.

Die Ausscheidungen sind in der PdCuAgRuRe-Legierung kleiner und stärker verteilt als in der PdCuAgRu-Legierung. Die PdCuAgRh-Legierung hat die kleinsten Ausscheidungen. Die Größe der Ausscheidungen ist aber kein Maß für die Qualität der Legierungen.

Die Messungen zeigen die hohe elektrische Leitfähigkeit der erfindungsgemäßen Palladium-Kupfer-Silber-Legierungen, die mehr als 1 Gew% Ruthenium, Rhodium oder Ruthenium und Rhodium enthalten, im Vergleich zu Hera 6321 (zwischen 2,3 mal und 3 mal so hoch). Gleichzeitig ist die Härte der Palladium-Kupfer-Silber-Legierungen mit Ruthenium oder Rhodium nur geringfügig (etwa 10%) geringer als die Härte von Hera 6321. Die Palladium-Kupfer-Silber-Legierungen enthaltend Ruthenium weisen sogar eine etwas höhere elektrische Leitfähigkeit auf als die Palladium-Kupfer-Silber-Legierungen gemäß der US 10 385 424 B1. Die Palladium-Kupfer-Silber-Legierungen enthaltend Rhodium zeichnet sich durch eine höhere Härte aus.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

**Patentansprüche**

1. Palladium-Kupfer-Silber-Legierung mit Palladium als Hauptkomponente wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium und als Rest Palladium, Kupfer und Silber und maximal 1 Gew% andere metallische Elemente einschließlich Verunreinigungen enthält.

2. Palladium-Kupfer-Silber-Legierung nach Anspruch 1, **dadurch gekennzeichnet, dass**

die Verunreinigungen in der Summe einen Anteil von maximal 0,9 Gew% in der Palladium-Kupfer-Silber-Legierung haben, bevorzugt von maximal 0,1 Gew%.

3. Palladium-Kupfer-Silber-Legierung nach Anspruch 1 oder 2, **dadurch gekennzeichnet, dass** die Palladium-Kupfer-Silber-Legierung bis zu 1 Gew% Rhenium enthält, wobei bevorzugt die Palladium-Kupfer-Silber-Legierung weniger als 0,1 Gew% Rhodium enthält, besonders bevorzugt die Palladium-Kupfer-Silber-Legierung mehr als 1 Gew% und maximal 2 Gew% Ruthenium und zwischen 0,1 Gew% und 1 Gew% Rhenium enthält, ganz besonders bevorzugt mindestens 1,1 Gew% und maximal 1,5 Gew% Ruthenium und zwischen 0,2 Gew% und 0,8 Gew% Rhenium enthält, speziell bevorzugt 1,1 Gew% Ruthenium und 0,4 Gew% Rhenium enthält.

4. Palladium-Kupfer-Silber-Legierung nach einem der vorangehenden Ansprüche, **dadurch gekennzeichnet, dass** die Palladium-Kupfer-Silber-Legierung mindestens 45 Gew% und maximal 55 Gew% Palladium, mindestens 30 Gew% und maximal 45 Gew% Kupfer und mindestens 8 Gew% und maximal 15 Gew% Silber enthält, bevorzugt die Palladium-Kupfer-Silber-Legierung mindestens 50 Gew% und maximal 53 Gew% Palladium, mindestens 35 Gew% und maximal 38 Gew% Kupfer und mindestens 9 Gew% und maximal 12 Gew% Silber enthält sowie mindestens 1,1 Gew% bis maximal 3 Gew% Ruthenium, Rhodium oder Ruthenium und Rhodium enthält, besonders bevorzugt die Palladium-Kupfer-Silber-Legierung mindestens 51 Gew% und maximal 52 Gew% Palladium, mindestens 36 Gew% und maximal 37 Gew% Kupfer und mindestens 10 Gew% und maximal 11 Gew% Silber enthält sowie mindestens 1,1 Gew% bis maximal 2 Gew% Ruthenium, Rhodium oder Ruthenium und Rhodium enthält und maximal 0,5 Gew% andere metallische Elemente, insbesondere zwischen 0,3 Gew% und 0,5 Gew% Rhenium enthält.

5. Palladium-Kupfer-Silber-Legierung nach einem der vorangehenden Ansprüche, **dadurch gekennzeichnet, dass** die Palladium-Kupfer-Silber-Legierung schmelzmetallurgisch hergestellt ist und anschließend durch Walzen und Tempern gehärtet ist, wobei vorzugsweise die Palladium-Kupfer-Silber-Legierung eine Härte von mindestens 350 HV1 aufweist.

6. Palladium-Kupfer-Silber-Legierung nach einem der vorangehenden Ansprüche, **dadurch gekennzeichnet, dass** die Palladium-Kupfer-Silber-Legierung eine Härte von mindestens 350 HV1 aufweist und/oder eine elektrische Leitfähigkeit von mindestens 19% IACS (11 * $10^6$ S/m) aufweist und/oder eine Bruchfestigkeit von mindestens 1300 MPa aufweist.

7. Palladium-Kupfer-Silber-Legierung nach einem der vorangehenden Ansprüche, **dadurch gekennzeichnet, dass** die Palladium-Kupfer-Silber-Legierung Ausscheidungen von Ruthenium, Rhodium oder einer Mischung aus Ruthenium und Rhodium oder einer Mischung aus Ruthenium und Rhenium enthält, wobei bevorzugt zumindest 90 Vol% der Ausscheidungen an Korngrenzen der Palladium-Kupfer-Silber-Legierung angeordnet sind, besonders bevorzugt zumindest 99 Vol% der Ausscheidungen an Korngrenzen der Palladium-Kupfer-Silber-Legierung angeordnet sind.

8. Palladium-Kupfer-Silber-Legierung nach einem der vorangehenden Ansprüche, **dadurch gekennzeichnet, dass** die Palladium-Kupfer-Silber-Legierung ein Gewichtsverhältnis von Palladium zu Kupfer von mindestens 1,2 und maximal 1,55 aufweist, bevorzugt ein Gewichtsverhältnis von Palladium zu Kupfer von mindestens 1,3 und maximal 1,5 aufweist, besonders bevorzugt ein Gewichtsverhältnis von Palladium zu Kupfer von mindestens 1,35 und maximal 1,45 aufweist, ganz besonders bevorzugt ein Gewichtsverhältnis von Palladium zu Kupfer von 1,41 aufweist.

9. Palladium-Kupfer-Silber-Legierung nach einem der vorangehenden Ansprüche, **dadurch gekennzeichnet, dass** die Palladium-Kupfer-Silber-Legierung ein Gewichtsverhältnis von Palladium zu Silber von mindestens 3,5 und maximal 5,5 aufweist, bevorzugt ein Gewichtsverhältnis von Palladium zu Silber von mindestens 4 und maximal 5,5 aufweist, besonders bevorzugt ein Gewichtsverhältnis von Palladium zu Silber von mindestens 4,6 und maximal 5,2 aufweist, ganz besonders bevorzugt ein Gewichtsverhältnis von Palladium zu Silber von 4,9 aufweist.

10. Palladium-Kupfer-Silber-Legierung nach einem der vorangehenden Ansprüche, **dadurch gekennzeichnet, dass** die Palladium-Kupfer-Silber-Legierung zumindest 1,1 Gew% Ruthenium, Rhodium oder Ruthenium und Rhodium enthält.

11. Palladium-Kupfer-Silber-Legierung nach einem der vorangehenden Ansprüche, **dadurch gekennzeichnet, dass** die Palladium-Kupfer-Silber-Legierung maximal 5 Gew% Ruthenium, Rhodium oder Ruthenium und Rhodium enthält, bevorzugt maximal 4 Gew% Ruthenium, Rhodium oder Ruthenium und Rhodium enthält, besonders bevorzugt maximal 3 Gew% Ruthenium, Rhodium oder Ruthenium und Rhodium enthält, ganz besonders bevorzugt maximal 2 Gew% Ruthenium, Rhodium oder Ruthenium und Rhodium enthält.

12. Palladium-Kupfer-Silber-Legierung nach einem der vorangehenden Ansprüche, **dadurch gekennzeichnet, dass** die Palladium-Kupfer-Silber-Legierung mehr als 1 Gew% und bis maximal 6 Gew% Rhodium oder Ruthenium enthält, bevorzugt mehr als 1 Gew% und bis maximal 3 Gew% Rhodium oder Ruthenium enthält, besonders bevorzugt zumindest 1,1 Gew% und bis maximal 2 Gew% Rhodium oder Ruthenium enthält, ganz besonders bevorzugt 1,5 Gew% Rhodium oder 1,5 Gew% Ruthenium enthält.

13. Palladium-Kupfer-Silber-Legierung nach einem der Ansprüche 1 bis 11, **dadurch gekennzeichnet, dass** die Palladium-Kupfer-Silber-Legierung mehr als 1 Gew% und bis maximal 6 Gew% Ruthenium und Rhenium enthält, bevorzugt zumindest 1,1 Gew% und bis maximal 3 Gew% Ruthenium und Rhenium enthält, besonders bevorzugt zumindest 1,1 Gew% und bis maximal 2 Gew% Ruthenium und Rhenium enthält, ganz besonders bevorzugt 1,1 Gew% Ruthenium und 0,4 Gew% Rhenium enthält.

14. Draht, Band oder Prüfnadel bestehend aus oder aufweisend eine Palladium-Kupfer-Silber-Legierung nach einem der vorangehenden Ansprüche, wobei vorzugsweise zumindest ein innerer Kern des Drahts, des Bands oder der Prüfnadel aus der Palladium-Kupfer-Silber-Legierung besteht.

15. Verwendung einer Palladium-Kupfer-Silber-Legierung nach einem der Ansprüche 1 bis 13 oder eines Drahts, eines Bands oder einer Prüfnadel nach Anspruch 14 zum Prüfen von elektrischen Kontakten oder zur elektrischen Kontaktierung oder zur Herstellung eines Schleifkontakts.

Figur 1

Figur 2

Figur 3

Figur 4

**EP 3 960 890 A1**

Europäisches Patentamt

European Patent Office

Office européen des brevets

# EUROPÄISCHER RECHERCHENBERICHT

Nummer der Anmeldung

EP 20 19 3903

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2017/218481 A1 (KLEIN ARTHUR S [US] ET AL) 3. August 2017 (2017-08-03) * Anspruch 1; Tabelle 1 * ----- | 1-15 | INV. C22C5/04 C22C30/00 G01R3/00 G01R1/067 C22F1/14 |
| A | WO 2016/159315 A1 (NHK SPRING CO LTD [JP]; YAMAMOTO PRECIOUS METAL CO LTD [JP] ET AL.) 6. Oktober 2016 (2016-10-06) * das ganze Dokument * ----- | 1-15 | |
| A | WO 2019/194322 A1 (TOKURIKI HONTEN KK [JP]) 10. Oktober 2019 (2019-10-10) * das ganze Dokument * ----- | 1-15 | |
| A | JP 2011 122194 A (TOKURIKI HONTEN KK) 23. Juni 2011 (2011-06-23) * das ganze Dokument * ----- | 1-15 | |

| RECHERCHIERTE SACHGEBIETE (IPC) |
|---|
| C22C G01R C22F |

Der vorliegende Recherchenbericht wurde für alle Patentansprüche erstellt

| Recherchenort | Abschlußdatum der Recherche | Prüfer |
|---|---|---|
| Den Haag | 27. Januar 2021 | Pircher, Ernst |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 19 3903

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-01-2021

| Im Recherchenbericht angeführtes Patentdokument | Datum der Veröffentlichung | Mitglied(er) der Patentfamilie | Datum der Veröffentlichung |
|---|---|---|---|
| US 2017218481 A1 | 03-08-2017 | CN 108699629 A | 23-10-2018 |
| | | DE 112017000561 T5 | 31-10-2018 |
| | | JP 2019508592 A | 28-03-2019 |
| | | KR 20190010527 A | 30-01-2019 |
| | | TW 201726929 A | 01-08-2017 |
| | | US 2017218481 A1 | 03-08-2017 |
| | | US 2019330713 A1 | 31-10-2019 |
| | | WO 2017132504 A1 | 03-08-2017 |
| WO 2016159315 A1 | 06-10-2016 | JP 6550457 B2 | 24-07-2019 |
| | | JP WO2016159315 A1 | 13-09-2018 |
| | | PH 12017501772 A1 | 19-03-2018 |
| | | SG 11201708015X A | 30-10-2017 |
| | | TW 201700745 A | 01-01-2017 |
| | | US 2018105902 A1 | 19-04-2018 |
| | | WO 2016159315 A1 | 06-10-2016 |
| WO 2019194322 A1 | 10-10-2019 | JP 6734486 B2 | 05-08-2020 |
| | | JP WO2019194322 A1 | 30-04-2020 |
| | | TW 201940708 A | 16-10-2019 |
| | | WO 2019194322 A1 | 10-10-2019 |
| JP 2011122194 A | 23-06-2011 | JP 5657881 B2 | 21-01-2015 |
| | | JP 2011122194 A | 23-06-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140266278 A1
- US 20100194415 A1
- US 1913423 A
- GB 354216 A

- US 2014377129 A1
- US 5833774 A
- US 10385424 B2
- US 10385424 B1